# EUROPÄISCHE PATENTANMELDUNG

(11) **EP 0 964 450 A1**
(43) Veröffentlichungstag der Anmeldung: **15.12.1999**
(21) Anmeldenummer: 99106322.3
(22) Anmeldetag: 26.03.1999
(51) Int. Cl.: H01L 27/06, H01L 23/485

(54) **Intergrierte Halbleiterschaltung mit einer Anschlussfläche**

(30) Priorität: 08.06.1998 DE 19825608
(71) Anmelder: SIEMENS AKTIENGESELLSCHAFT, 80333 München (DE)
(72) Erfinder: Savignac, Dominique, Dr., 85737 Ismaning (DE); Feurle, Robert, 85579 Neubiberg (DE); Schneider, Helmut, 80993 München (DE)

(57) **Zusammenfassung**

Bei einer integrierten Halbleiterschaltung ist vorzugsweise unterhalb eines Anschlußpads (3) eine Vielzahl von parallel verlaufenden Dotierungsgebieten (4, 5, 6, 7) angeordnet. Um entsprechend einer vorgegebenen Ein-/Ausgangscharakteristik eine bestimmte kapazitive Belastung des Pads (3) einzustellen, wird ein Teil der Dotierungsgebiete (5, 6, 7) mit dem Pad (3) verbunden. Die Kapazitätsabstufung wird verfeinert, indem über den Dotierungsgebieten jeweils angeordnete Polysiliziumflächen (8, 9, 10, 11) mit dem Substrat (1) oder dem Pad (3) verbunden werden. Zur Einstellung eines gewünschten Anschlußwiderstands wird ein in die Anschlußleitung (13) zum Pad (3) geschalteter Polysiliziumwiderstand (12) getrimmt. Die modulare Struktur ermöglicht eine genaue Einstellung der Ein-/Ausgangscharakteristik des Pads (3) ohne zusätzlichen Flächenbedarf.

## Beschreibung

Die Erfindung betrifft eine integrierte Halbleiterschaltung, die ein Substrat mit einer Dotierung eines ersten Dotierungstyps umfaßt sowie eine Anschlußfläche für Ein- oder Ausgabe eines zu verarbeitenden Signals oder zur Zuführung eines Versorgungspotentials.

Integrierte Halbleiterschaltungen weisen bekanntlich Anschlußflächen, sogenannte Pads, auf, die an Anschlußstifte eines Gehäuses kontaktiert sind und über die die von der Halbleiterschaltung zu verarbeitenden Eingangs- oder Ausgangssignale zu- bzw. abgeführt werden oder an die ein Versorgungspotential angelegt wird. Insbesondere bei den Pads für Signaleingabe und -ausgabe besteht das Erfordernis, eine Anpassung an die an die Anschlußfläche angeschlossenen Leitungen, z.B. Bonddraht, Gehäusepin, Leiterbahn auf der Schaltungsplatine, vorzunehmen.

Halbleiterschaltkreise mit dem gleichen Schaltungsentwurf sollen beispielsweise an verschiedene Bussysteme angeschlossen werden. Durch geeignete Schaltungsmaßnahmen sind dann die Ein-/Ausgabeparameter der Anschlüsse durch eine geeignete Kapazitäts- und Widerstandsbeschaltung auf den gewünschten Wert anzupassen. Wenn hierzu entsprechende Bauelemente außerhalb der integrierten Halbleiterschaltung verwendet werden, führt dies zu einem höheren Aufwand beim Platinenentwurf und dementsprechenden Nachteilen, z.B. erhöhtes Ausfallrisiko. Wenn solche Bauelemente andererseits mit herkömmlichen Mitteln auf dem Halbleiterchip integriert realisiert werden, wird der Flächenbedarf der Schaltung insbesondere durch die Realisierung von Kapazitäten erhöht. Zur Herstellung des integrierten Kondensators sind eine Vielzahl von bis in tiefere Schichten des integrierten Schaltkreises hineinreichende Prozeßschritte erforderlich. Die integrierte Realisierung bedingt daher außerdem zusätzlichen Entwicklungsaufwand und eine Vielzahl von jeder Anpassungsvariante eigens zugeordneten Belichtungsmasken.

In der Literaturstelle IBM Technical Disclosure Bulletin, Band 37, Nr. 9, September 1994, Seiten 593 bis 594 ist eine integrierte Schaltung mit einer Kapazitätsstruktur zur Entkopplung der Versorgungsspannungszuführung beschrieben. Der Entkopplungskondensator umfaßt ein n-Wannengebiet in einem p-Substrat, auf dem durch ein dünnes Oxid getrennt eine Polysiliciumschicht angeordnet ist. Ein Pol der Versorgungsspannung ist an die Wanne, der andere an Polysilicium angeschlossen.

Die Aufgabe der Erfindung besteht darin, eine integrierte Halbleiterschaltung anzugeben, bei der die Anpassung an Ein-/Ausgangsparameter ihrer Anschlüsse mit geringerem Aufwand durchführbar ist.

Diese Aufgabe wird durch eine integrierte Halbleiterschaltung nach den Merkmalen des Patentanspruch 1 gelöst.

Die Struktur der benachbarten Dotierungsgebiete ist modular aufgebaut. Vorteilhafterweise sind Polysiliziumbahnen oberhalb der Dotierungsgebiete angeordnet. Durch eine geeignete Metallisierung werden die Dotierungsgebiete und Polysiliziumbahnen mit der Anschlußfläche (oder Anschlußpad) oder dem Substrat und damit dem Versorgungspotential verbunden. Je nach Anzahl der verbundenen Dotierungsgebiete und Polysiliziumflächen liegt dann am Anschlußpad eine gewünschte kapazitive Last an. Außerdem wird ein in der Anschlußleitung angeordneter Widerstand auf einen gewünschten Wert getrimmt. Das Eingangs-/Ausgangszeitverhalten des Pads wird dadurch insgesamt auf eine gewünschte RC-Konstante eingestellt. Die erfindungsgemäße Struktur ermöglicht eine feine Abstufung des RC-Verhaltens für das Anschlußpad in einem breiten Einstellungsbereich.

Die Struktur aus Dotierungsgebieten und Polysiliziumflächen befindet sich in tief liegenden Schichten des integrierten Schaltkreises. Die individuelle Verdrahtung der Struktur zum Anschluß an das Pad hingegen beeinflußt nur die oberen Schichten des Schaltkreises. Das gleiche Grundlayout kann daher für eine Vielzahl von unterschiedlichen Eingangs-/Ausgangscharakteristika verwendet werden. Die Dotierungsgebiete und Polysiliziumbahnen befinden sich in solchen Gebieten des Halbleiterschaltkreises, die von anderen aktiven Elementen, z.B. Transistoren oder Dioden, nicht belegt sind, vorzugsweise jedoch unterhalb der Anschlußfläche. Die Gebiete sind in vertikale Richtung gesehen ausreichend weit von der Anschlußfläche entfernt, so daß sie beim Bonden nicht beschädigt werden.

Die Erfindung und deren vorteilhafte Ausgestaltungen sind in den in der Zeichung dargestellten Figuren gezeigt und werden nachfolgend näher erläutert. Es zeigen
- Figur 1: einen Querschnitt durch einen Halbleiterchip im Bereich eines Anschlußpads und
- Figur 2: eine Aufsicht auf die modulare Kapazitätsstruktur.

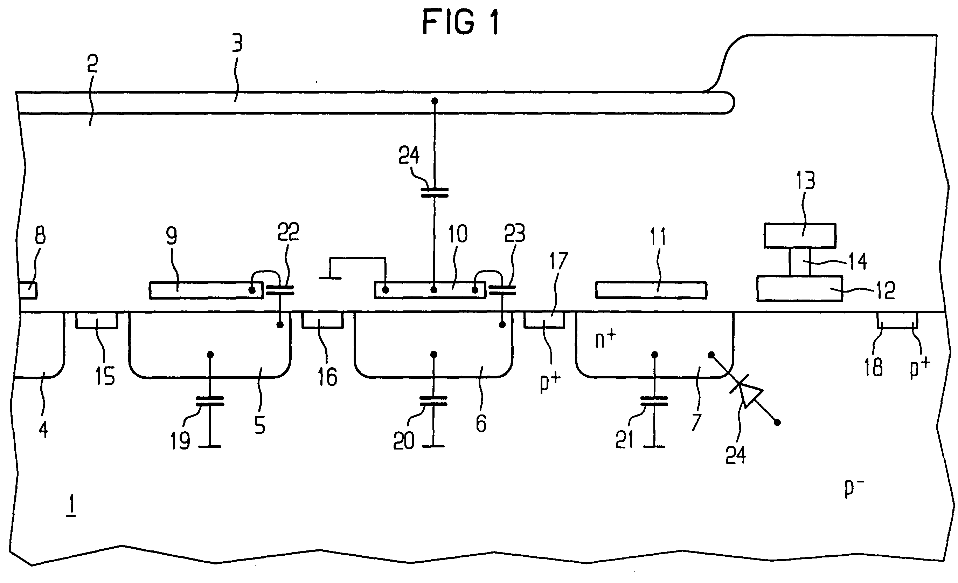

Der Querschnitt in Figur 1 zeigt ein schwach p⁻-dotiertes Halbleitersubstrat 1, über dem getrennt durch eine Feldoxidschicht 2 ein Teil einer Anschlußfläche 3 angeordnet ist. Auf der aus Metall bestehenden Anschlußfläche 3 wird ein Bonddraht aufgestempelt, um eine Verbindung mit einem Anschlußstift herzustellen, der nach außerhalb des Gehäuses führt. Die Anschlußfläche 3 befindet sich in der obersten Metallisierungsebene des Halbleiterchips. Über das Pad 3 werden von der Schaltung zu verarbeitende Eingangssignale zugeführt oder verarbeitete Ausgangssignale abgegeben. Außerdem kann ein Potential einer Versorgungsspannung eingespeist werden, beispielsweise ein positives Versorgungspotential.

Um eine möglichst gute Signalübertragung zu erreichen, ist es erforderlich, die Eingabe-/Ausgabecharakteristik des Anschlußpads 3 auf eine gewünschte Zeitkonstante einzustellen. Diese Zeitkonstante hängt unter anderem von der Länge des Bonddrahts, der Länge und Ausgestaltung des Anschlußstifts sowie den Eigenschaften der auf der Schaltungsplatine angeordneten Leitungen ab. Um die Anschlüsse des Halbleiterschaltkreises an einen standardisierten Datenbus anzuschließen, ist überlicherweise erforderlich, daß die Zeitkonstante innerhalb gewisser Toleranzen liegt.

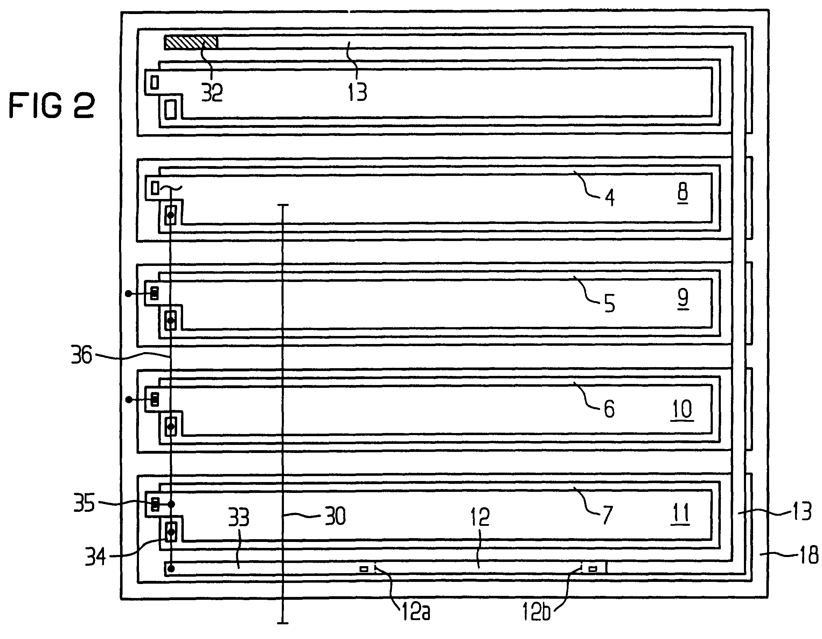

Zur Einstellung der Zeitkonstante des Anschlußpads 3sind im Halbleitersubstrat 1 unterhalb des Pads 3 Dotierungsgebiete 4, 5, 6, 7 angeordnet. Die Dotierungsgebiete haben im Vergleich zum Halbleitersubstrat einen entgegengesetzten n⁺-Dotierungstyp. Sie sind als Wannendotierungsgebiete ausgeführt, d.h. sie weisen eine im Vergleich zu den Drain- und Sourcedotierungsgebieten von MOS-Transistoren wesentlich tiefer gehende Dotierung mit einer um etwa zwei Größenordnungen niedrigeren Dotierstoffkonzentration auf. Jedes Dotierungsgebiet bildet mit dem Substrat einen pn-Übergang von denen der pn-Übergang 24 symbolisch als Diode dargestellt ist. Jedes der Dotierungsgebiete 4, ..., 7 kann optional mit der Anschlußfläche 3 verbunden werden. Das Halbleitersubstrat 1 ist mit dem negativsten der an der Schaltung anliegenden Potentiale verbunden, üblicherweise mit Masse. Je nach gewünschter kapazitiver Belastung des Anschlußpads 3 wird eine geeignete Anzahl von Dotierungsgebieten mit dem Pad 3 verbunden. Die jeweiligen pn-Übergänge zwischen Dotierungsgebiet und Substrat wirken als Kapazitäten 19, 20, 21. Die Verbindung wird über Leiterbahnen 13, 12 wie in Zusammenhang mit Figur 2 beschrieben hergestellt.

Vorzugsweise ist oberhalb der Dotierungsgebiete 4, ..., 7 je eine Polysiliziumfläche 8, ..., 11 angeordnet. Zwischen Polysiliziumfläche und Dotierungsgebiet ist ein Oxid in der Dicke des Gateoxids eines MOS-Transistors ausgebildet. Das Oxid kann auch ein Feldoxid mit größerer Dicke sein. Je nach gewünschter kapazitiver Belastung des Pads 3 wird auch ein Teil der Polysiliziumflächen angeschlossen, entweder an das Substrat 1 oder an das Anschlußpad 3. Erstere Verbindung wird an ein Substratanschlußdotierungsgebiet 18 geführt, welches die Anordnung der Wannendotierungsgebiete und Polysiliziumflächen umgibt. Der im Querschnitt sichtbare Teil 18 des Substratanschlußdotierungsgebiets weist im Vergleich zum Substrat 1 den gleichen Dotierungstyp, jedoch mit wesentlich höherer Dotierstoffkonzentration (p⁺) auf. Letztere Verbindung der Polysiliziumflächen an das Pad 3 erfolgt über die Metalleiterbahn 13. Diese verläuft in der ersten unteren Metallisierungsebene. Sie weist einen Abschnitt auf, dessen Widerstandswert auf einen vorgebenen Wert getrimmt wird, um den Widerstandsanteil des RC-Verhaltens einzustellen. Zweckmäßigerweise wird der Widerstandsabschnitt aus Polysilizium gebildet. In diesem Abschnitt ist die Metalleiterbahn 13 unterbrochen und wird mit dem Polysiliziumabschnitt 12 überbrückt, indem dieser über je einen Kontakt mit den unterbrochenen Teilen der Metalleiterbahn 13 verbunden ist, wobei der Abstand der Kontakte ein Maß für den Widerstand ist.

In der in Figur 1 gezeigten Ausführung sind speziell die Dotierungsgebiete 6 und 7 über die leitende Verbindung 12, 13 an das Pad 3 angeschlossen. Deren gegenüber dem Substrat gebildeten Kapazitäten 20 bzw. 21 sind daher wirksam am Pad 3 angeschlossen. Die Polysiliziumfläche 11 ist unverbunden. Die Polysiliziumfläche 10 ist mit dem Substratkontakt verbunden, so daß eine zwischen Polysiliziumfläche 10 und Dotierungsgebiet 6 über das dazwischen angeordnete Gateoxid gebildete Kapazität wirksam ist, die elektrisch parallel zur Kapazität 20 liegt. Außerdem ist eine Kapazität 24 zwischen dem Pad 3 und der Polysiliziumfläche 10 wirksam, die ebenfalls parallel zu den Kapazitäten 20, 23 liegt. Die Folysiliziumfläche 9 ist über die Verbindungsleitungen 12, 13 an das Pad 3 angeschlossen. Dadurch ist eine Kapazität 22 zwischen Polysiliziumfläche 9 und Dotierungsgebiet 5 wirksam. In Reihe zu der Kapazität 22 ist außerdem die Sperrschichtkapazität 19 wirksam.

Je nach optionalem Anschluß von Polysiliziumfläche und Dotierungsgebiet können Kapazitäten zwischen Polysiliziumfläche und Metallpad, Polysiliziumfläche und Dotierungsgebiet sowie Dotierungsgebiet und Substrat wirksam geschaltet werden. Bei einer Vielzahl von nebeneinander angeordneten Dotierungsgebieten und Polysiliziumflächen ermöglicht dies eine sehr feine Kapazitätsabstufung in einem breiten Wertebereich.

In Figur 2 ist eine Aufsicht auf eine Kapazitätsstruktur gezeigt. Die Kapazitätsstruktur liegt zweckmäßigerweise unterhalb eines Anschlußpads, so daß keine zusätzliche Fläche verbraucht wird. Da die Strukturen durch eine dicke Oxidschicht 2 vom Pad 3 ausreichend weit entfernt liegen, wird die Struktur durch das Aufstempeln des Bonddrahts nicht beschädigt. Ohne weiteres kann die Kapazitätsstruktur auch außerhalb eines Pads in ansonsten nicht benutzten aktiven Gebieten des Halbleiterchips angeordnet werden. Die Anschlußleitungen 12, 13 sind dann entsprechend zu führen. Die Schnittlinie 30 in der Figur 2 entspricht dem in Figur 1 im Querschnitt dargestellten Ausschnitt.

Die Dotierungsgebiete und Polysiliziumflächen sind streifenförmig, rechteckig ausgebildet und liegen parallel zueinander. Die Anschlußleitung 13 umgibt an drei Seiten die von den Dotierungsgebieten eingenommene Fläche. Am Anschluß 32 ist die Metalleiterbahn 13 an das Pad nach oben kontaktiert. Im unteren Abschnitt 12a bis 12b der Verbindungsleitung ist die Metallisierung unterbrochen. Im Abschnitt 33 sind Metalleiterbahn und Metallisierung übereinander geführt. Abhängig davon, an welcher Stelle die Polysiliziumleitung 12 mit der Metallisierung 13 verbunden wird, wird der Widerstand der Verbindungsleitung auf einen vorbestimmten Wert eingestellt. Gegebenenfalls sind Polysilizumbahn und Metalleliterbahn im Abschnitt 33 mehrfach kontaktiert. Die Dotierungsgebiete sowie die darüberliegenden Polysiliziumflächen weisen an ihrem jeweiligen linken Rand je ein Anschlußgebiet 34 bzw. 35 auf, über welches sie anschließbar sind. Das Anschlußgebiet 34 der Dotierungsgebiete ist an die Verbindungsleitung anschließbar, die in diesem Abschnitt wieder als Metalleiterbahn weitergeführt wird. Der Anschluß 35 für die Polysiliziumfläche kann entweder an die Leiterbahn zur Verbindung an das Pad angeschlossen werden oder an das Substrat. Im letzteren Fall wird die Leiterbahn 35 an den Substratring 18 kontaktiert. In Übereinstimmung mit der Figur 1 wird das Dotierungsgebiet 7 an die Verbindungsleitung zum Pad angeschlossen, die in diesem Abschnitt 36 symbolisch dargestellt ist. Das Polysiliziumgebiet 11 ist ebenfalls an die Metalleiterbahn 36 kontaktiert. Bei der benachbarten Teilstruktur ist das Dotierungsgebiet 6 an den Leiterbahnabschnitt 36 angeschlossen, die Polysiliziumfläche 10 ist an den Substratring 18 kontaktiert. Bei der wiederum benachbarten Teilstruktur ist die Polysiliziumfläche 9 an den Leiterbahnabschnitt 36 angeschlossen, das Dotierungsgebiet bleibt unverbunden. Je nach erforderlicher Kapazitätsbelastung des Anschlußpads 3 sind gegebenenfalls auch Anteile der übrigen Dotierungsgebiete und Polysiliziumflächen an die Verbindungsleitung 36 und letztere alternativ auch an das Substrat angeschlossen.

Zwischen den Dotierungsgebieten sind Abzweigungen 15, 16, 17 des Substratrings 18 angeordnet. Diese bestehen ebenfalls wie der Substratring 18 aus p⁺-dotierten Gebieten. Sie dienen zur Verbesserung der Latchup-Festigkeit, indem Ladungsträger abgesaugt werden, die bei am Pad auftretenden Über- oder Unterschwingern des angelegten Signals entstehen können.

## Patentansprüche

1. Integrierte Halbleiterschaltung umfassend ein Substrat (1) mit einem ersten Dotierungstyp, eine Anschlußfläche (3) für Ein- oder Ausgabe eines zu verarbeitenden Signals oder zur Zuführung eines Versorgungspotentials und eine Vielzahl von benachbarten Dotierungsgebieten (4, 5, 6, 7), die einen gegenüber dem Substrat (1) entgegengesetzten Dotierungstyp aufweisen, von denen ein Teil (5, 6, 7) der Dotierungsgebiete über eine leitende Verbindung (12, 13, 36), die einen Abschnitt (12) aufweist, der einen vorgegebenen Widerstandswert hat, an die Anschlußfläche (3) angeschlossen ist.

2. Integrierte Halbleiterschaltung nach Anspruch 1,
**dadurch gekennzeichnet**, daß
oberhalb mindestens eines der Dotierungsgebiete (4, 5, 6, 7) eine Schicht aus Polysilizium (8, 9, 10, 11) angeordnet ist, die entweder mit dem Substrat (1) oder mit der Anschlußfläche (3) leitend verbunden ist.

3. Integrierte Halbleiterschaltung nach Anspruch 1 oder 2
**dadurch gekennzeichnet**, daß
der Widerstandswert des Abschnitts (12) der leitenden Verbindung größer ist als der Widerstandswert des übrigen Teils der Verbindung (13, 36).

4. Integrierte Halbleiterschaltung nach Anspruch 3,
**dadurch gekennzeichnet**, daß
der Abschnitt (12) der leitenden Verbindung mit dem vorgegebenen Widerstandswert aus Polysilizium besteht, der übrige Teil (13, 36) aus einem Metall.

5. Integrierte Halbleiterschaltung nach Anspruch 3,
**dadurch gekennzeichnet**, daß
der aus Metall gebildete Abschnitt (13, 36) der Verbindung und der Abschnitt (12) aus Polysilizium teilweise übereinander angeordnet sind, daß der Abschnitt (13, 36) aus Metall unterbrochen ist, wobei die Unterbrechung unter dem Abschnitt (12) aus Polysilizium liegt, und daß an die Unterbrechung angrenzenden Teile des Abschnitts aus Metall an den Abschnitt aus Polysilizium kontaktiert (14) sind.

6. Integrierte Halbleiterschaltung nach einem der Ansprüche 1 bis 5,
**dadurch gekennzeichnet,** daß
die Dotierungsgebiete (4, 5, 6, 7) in Aufsicht rechteckförmig ausgebildet sind und parallel zueinander angeordnet sind.

7. Integrierte Halbleiterschaltung nach einem der Ansprüche 1 bis 6,
**dadurch gekennzeichnet**, daß
die Dotierungsgebiete (4, 5, 6, 7) unterhalb der Anschlußfläche (3) angeordnet sind.

8. Integrierte Halbleiterschaltung nach einem der Ansprüche 1 bis 7,
**dadurch gekennzeichnet**, daß
die Dotierungsgebiete (4, 5, 6, 7) Wannendotierungsgebiete sind mit einer gegenüber Dotierungsgebieten für Drain- und Sourceanschlüsse von Transistoren tiefergehenden und geringeren Konzentration von Dotierstoffatomen.

9. Integrierte Halbleiterschaltung nach einem der Ansprüche 1 bis 8,
**dadurch gekennzeichnet**, daß
zwischen den Dotierungsgebieten (4, 5, 6, 7) jeweils ein weiteres Dotierungsgebiet (15, 16, 17) mit im Vergleich zum Substrat (1) gleichen Dotierungstyps und höherer Dotierstoffkonzentration angeordnet ist.

10. Integrierte Halbleiterschaltung nach einem der Ansprüche 1 bis 9,
**dadurch gekennzeichnet**, daß
die Dotierungsgebiete (4, 5, 6, 7) und die leitende Verbindung von einem Dotierungsgebiet (18) im Vergleich zur Substrat (1) gleichen Dotierungstyps und höherer Dotierstoffkonzentration umgeben sind.
